Europäisches Patentamt

European Patent Office

Office européen des brevets

(19)

(11) **EP 1 227 524 A2**

(12) **EUROPEAN PATENT APPLICATION**

(43) Date of publication:
**31.07.2002  Bulletin 2002/31**

(51) Int Cl.7: **H01L 31/18**, H01L 31/048

(21) Application number: **02001817.2**

(22) Date of filing: **25.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **26.01.2001  JP 2001019231**

(71) Applicant: **EBARA CORPORATION**
**Ohta-ku, Tokyo (JP)**

(72) Inventors:
• **Shibata, Akio**
  **Tokyo (JP)**

• **Emoto, Makiko**
  **Tokyo (JP)**
• **Yokota, Hiroshi**
  **Fujisawa-shi, Kanagawa-ken (JP)**

(74) Representative: **Wagner, Karl H., Dipl.-Ing. et al**
**Wagner & Geyer,**
**Patentanwälte,**
**Gewürzmühlstrasse 5**
**80538 München (DE)**

(54) **Solar cell and method of manufacturing same**

(57)    A face side of the semiconductor crystal substrate is brought into contact with an electrolytic liquid containing a fluoride, and an electrode is disposed in the electrolytic liquid. A current is produced between the electrode and the semiconductor crystal substrate and applying light to a reverse side of the semiconductor crystal substrate to generate pairs of holes and electrons. The semiconductor crystal substrate is etched by combining the holes with ions in the electrolytic liquid thereby to form a multiplicity of through-holes in the semiconductor crystal substrate.

# FIG. 1

**Description**

BACKGROUND OF THE INVENTION

Field of the Invention:

The present invention relates to a solar cell and a method of manufacturing a solar cell, and more particularly to a see-through type solar cell having a multiplicity of through-holes defined in a semiconductor crystal substrate and a method of defining such through-holes.

Description of the Related Art:

Solar cells made of amorphous-silicon have heretofore been in wide use. The amorphous-silicon solar cells have a small film thickness of about several μm (micrometers), can well be mass-produced, and can easily be machined. The amorphous-silicon solar cells are able to sufficiently meet demands in the market for see-through type solar cells, which have a number of minute through-holes for increased efficiency of solar radiation reception and also for increased designability.

However, the amorphous-silicon solar cells are used in a limited range of applications because their photoelectric conversion efficiency is low. As a result, solar cells using monocrystalline or polycrystalline silicon substrates are preferable for use in fields that require higher photoelectric conversion efficiency. The monocrystalline or polycrystalline silicon substrates, however, are several tens thicker than the amorphous-silicon films, that are are several μm (micrometers) thick. A process of forming a number of minute through-holes in a thick monocrystalline or polycrystalline silicon substrate in producing a see-through type solar cell would entail a large expenditure of time and energy, posing a problem on the cost of manufacture of the see-through type solar cell.

Specifically, it has heretofore been customary to form a number of minute through-holes in a see-through type solar cell according to a laser beam perforating process or an etching process using an alkaline solution. However, these processes are primarily aimed at processing thin films having a thickness of about several μm (micrometers). Even if these processes are applied to silicon crystal substrates, which are at least 100 μm (micrometers) thick, it is difficult to produce a number of minute through-holes in the substrates in a short period of time and at a low cost.

SUMMARY OF THE INVENTION

It is therefore an object of the present invention to provide a see-through type solar cell, which has high photoelectric conversion efficiency and can be manufactured at a low cost, and a method of manufacturing such a see-through type solar cell.

To achieve the above object, there is provided in accordance with an aspect of the present invention a method of manufacturing a solar cell, comprising bringing a face side of a semiconductor crystal substrate into contact with an electrolytic liquid containing a fluoride; placing an electrode in the electrolytic liquid; producing a current between the electrode and the semiconductor crystal substrate and applying light to a reverse side of the semiconductor crystal substrate to generate pairs of holes and electrons, the holes moving to the face side of the semiconductor crystal substrate; and etching the semiconductor crystal substrate by combining the holes with ions in the electrolytic liquid thereby to form a multiplicity of through-holes in the semiconductor crystal substrate.

The semiconductor crystal substrate comprises a monocrystalline silicon substrate or a polycrystalline silicon substrate. Also, the semiconductor crystal substrate comprises a substrate having a thickness of at most 150 μm (micrometers).

According to another aspect of the present invention, there is also provided a solar cell comprising a semiconductor crystal substrate having a thickness of at most 150 μm (micrometers) and a multiplicity of through-holes defined therein.

In the solar cell, the semiconductor crystal substrate comprises a monocrystalline silicon substrate or a polycrystalline silicon substrate.

The through-holes are preferably formed by bringing a surface of the semiconductor crystal substrate into contact with an electrolytic liquid containing a fluoride, producing a current through the semiconductor crystal substrate, and applying light to an opposite surface of the semiconductor crystal substrate. The through-holes may be formed by punching with laser beam irradiation.

With the above arrangement, since holes produced by the application of light to the reverse side of the semiconductor crystal substrate and ions in the electrolytic liquid containing a fluoride are combined with each other to carry out an etching process (photo-electrolytic etching process), the etching process can produce highly linear etching of the substrate. Therefore, a number of through-holes can easily be formed in a crystal substrate having a thickness of more than 100 μm (micrometers) or greater with a simple facility at a low cost.

It is possible to provide a see-through type solar cell of high designability using a crystalline silicon substrate, which can provide high photoelectric conversion efficiency. Since the crystalline silicon substrate can have a relatively small thickness of at most 150 μm (micrometers), the solar cell is flexible. The light-blocking ratio of the solar cell can be changed by changing the opening area ratio as desired depending on the application of the solar cell.

The above and other objects, features, and advantages of the present invention will become apparent from the following description when taken in conjunction with the accompanying drawings, which illustrate a preferred embodiment of the present invention by way of example.

BRIEF DESCRIPTION OF THE DRAWINGS

FIG. 1 is a cross-sectional view of an apparatus for forming through-holes in a crystal substrate by photo-electrolytic etching;
FIG. 2 is a schematic view showing the principles of electrolytic etching based on the application of light;
FIG. 3 is a modification of an apparatus shown in FIG. 1; and
FIG. 4 is a cross-sectional view of a solar cell module.

DETAILED DESCRIPTION OF THE PREFERRED EMBODIMENTS

A method of manufacturing a solar cell according to the present invention will be described below. In the method, a monocrystalline silicon substrate is prepared at first. At this time, a uniform monocrystalline silicon substrate having a thickness of 150 μm (micrometers) or less can continuously be pulled up from a molten mass of monocrystalline silicon under precisely adjusted pull-up conditions. Then, the monocrystalline silicon substrate is cut into a rectangular sheet having suitable dimensions. While the monocrystalline silicon substrate is preferably doped with an n-type impurity, it may be doped with a p-type impurity or may have a p-n junction. In the present embodiment, the monocrystalline silicon substrate will be processed to manufacture a solar cell. However, the present invention is also applicable to a polycrystalline silicon substrate or a compound semiconductor substrate such as of gallium arsenide.

An insulating film such as a silicon nitride film or the like is formed on the entire surface (face side) of the monocrystalline silicon substrate by CVD (Chemical Vapor Deposition) or the like. Then, a multiplicity of minute openings are formed in the insulating film by photolithography and etching. The minute openings are preferably circular holes having diameters ranging from 50 to 400 μm (micrometers) and arranged at regular intervals to provide an opening area ratio of about 20 %. The diameters and opening area ratio of the minute openings can be set to desired values depending on the application of the solar cell.

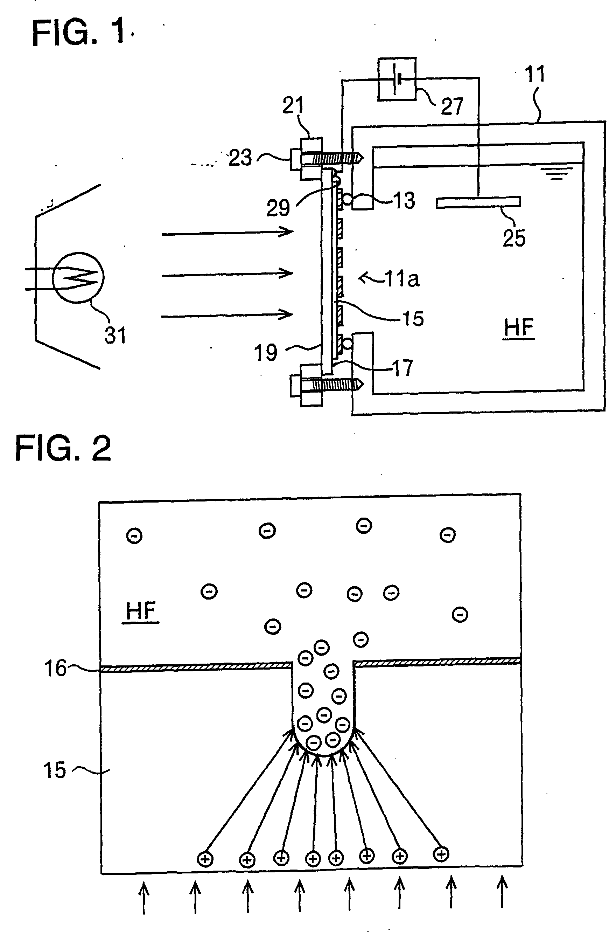

Then, the monocrystalline silicon substrate is etched through the openings defined in the insulating film, thus forming a multiplicity of through-holes in the monocrystalline silicon substrate. The monocrystalline silicon substrate should preferably be etched by an apparatus shown in FIG. 1. As shown in FIG. 1, the apparatus includes a container 11 having an opening 11a defined in a sidewall thereof. A crystal substrate 15 is mounted on the container 11 over the opening 11a in a watertight fashion by a seal 13 such as an O-ring or the like. The crystal substrate 15 is fixed to the container 11 in covering relation to the opening 11a by a transparent glass panel 19 having a transparent electrically conductive film 17. The transparent glass panel 19 is securely fastened to the container 11 by holders 21 and screws 23.

Then, an acid electrolytic liquid containing a fluoride, i.e., a solution of hydrofluoric acid HF, is introduced into the container 11 in which the solution is held in contact with the crystal substrate 15. Then, the regions of the crystal substrate 15 which correspond to the openings in the insulating film 16 are contacted by the solution of hydrofluoric acid, and the opposite surface (reverse side) of the crystal substrate 15 is held in contact with the transparent electrically conductive film 17 on the glass panel 19. An electrode 25 is placed in the solution of hydrofluoric acid and connected to a negative electrode of a DC power supply 27. Therefore, the electrode 25 serves as a cathode or negative electrode. The positive electrode of the DC power supply 27 is connected to the reverse side of the crystal substrate 15 through a terminal 29 and the transparent electrically conductive film 17. Therefore, the crystal substrate 15 serves as an anode or positive electrode.

A light source 31 such as a halogen lamp or the like is positioned such that light emitted from the light source 31 is applied through the glass panel 19 and the transparent electrically conductive film 17 to the reverse side of the crystal substrate 15. Therefore, pairs of holes having positive charges and electrons are generated on the reverse side of the crystal substrate 15 by the application of light. A circuit is now made in which negative current flows from the DC power supply 27 through the negative electrode 25 and the solution of hydrofluoric acid HF and then from the transparent electrically conductive film 17 to the DC power supply 27.

As shown in FIG. 2, holes which are formed on the reverse side of the crystal substrate 15 moves through the crystal substrate 15 to the face side thereof according to the current flow. At the face side, which contacts to the solution as the negative electrode, the holes are combined with negative ions in the solution of hydrofluoric acid (HF) at the openings of the crystal substrate 15 which are free of the insulating film and directly contact the solution of hydrofluoric acid (HF). An etching reaction then progresses according to the following formula:

$$Si + 4HF + 2F^- + 2h^+ \rightarrow SiF_6^{2-} + H_2 + 2H^+$$

Since the etching reaction is produced by the combination of holes supplied from the reverse side of the substrate 15 and negative ions supplied from the electrolytic solution at the openings in the insulating film on the face side of the crystal substrate 15, the crystal substrate 15 is etched in a direction perpendicular to the plane of the crystal substrate 15. Therefore, the etching reaction is anisotropic. When the holes formed by the progress of the etching reaction reach the reverse side of the crystal substrate 15, through-holes are formed in the crystal substrate 15. While a single etched region is shown in FIG. 2, a number of such through-holes are formed in the crystal substrate 15 at the same time because of the openings defined in the insulating film. The solution of hydrofluoric acid (HF) should preferably have a concentration of about 2.5 - 10.0 %, and several % of methanol or the like may be mixed with the solution of hydrofluoric acid (HF) for the purpose of smoothly removing hydrogen gases generated in the etching reaction.

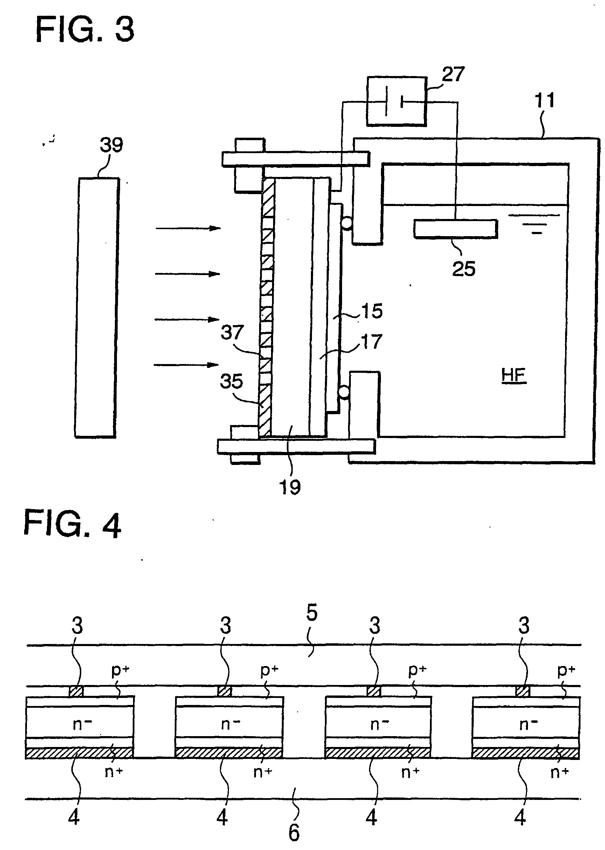

FIG. 3 shows another embodiment of forming through-holes in the substrate. In this embodiment, a screen board 35 having a multiplicity of openings 37 is disposed at the inlet side of light as a mask instead of forming an insulating film on the substrate and openings in the insulating film. A solution of hydrofluoric acid (HF), is introduced into the container 11 in which the solution is held in contact with the crystal substrate 15. The screen board 35 having a multiplicity of openings 37 is disposed adjacent to the transparent glass panel 19, and the reverse side of the crystal substrate 15 contacts to the transparent conductive film 17 on the glass panel 19. The electrode 25 is disposed in the solution of hydrofluoric acid (HF), and connected to the negative electrode of the DC power supply 27, thus forming a current path. Parallel lights are emitted from a parallel light source 39 onto the screen board 35, the lights is selectively irradiated through the openings 37 of the screen board 35 on the reverse side of the substrate 15. As described above, photo-electrolytic etching proceeds at the portion where the light is selectively irradiated. Accordingly, anisotropic etching in the crystal substrate 15 is carried out selectively in accordance with the opening pattern of the screen board 35. Therefore, a number of through-holes can be formed at the same time in a crystal substrate by using the screen board having openings, as in the case with forming an insulating layer on the substrate and openings in the insulating film.

For forming a number of through-holes in the crystal substrate, laser beam punching can be used. YAG laser can be used easily for forming a number of through-holes in the crystal substrate of approximately 150 $\mu$m (micrometers) thickness in a short time. By using YAG laser beam punching, through-holes having diameter of 0.5 - 2.0 mm can be formed arbitrarily at opening area ratio of 1 - 30 %. Especially, according to the present invention, because the thickness of the semiconductor crystal substrate is relatively thin of approximately less than 150 $\mu$m (micrometers), it takes shorter time for forming through-holes, that is 1/7 times comparing to the substrate having thickness of 350 $\mu$m (microm-

eters). Further, by using YAG laser beam punching, the diameter of the through-holes can be adjusted easily. Since each of the diameters and positions of the through-holes can be adjusted, arbitrary pattern of light transmission in the substrate can be obtained by forming arbitrary character pattern, figure pattern, or drawing pattern.

A method of manufacturing a solar cell module using the above monocrystalline silicon substrate having a number of minute through-holes therein will be described below.

First, when the insulating film such as a silicon nitride film or the like has been used as a mask for forming the through-holes, the insulating film is removed from the crystal substrate 15. In this example, an impurity is doped into the entire crystal substrate 15 in advance, producing an n$^-$ layer.

Then, an impurity such as phosphor or the like is diffused into a surface of the crystal substrate 15, producing an n$^+$ layer at a face side of the substrate. Next, reverse side of the crystal substrate 15 is coated with a paste of aluminum, which is then heated and diffused into the substrate to form p layer at reverse side thereof. Thus, a pn-junction is formed. Then, an anti-reflection film of silicon nitride or so on is formed on the surface of the substrate. A pattern of an electrically conductive paste primarily composed of a fine powder of metal is formed on each of the face and reverse sides of the crystal substrate 15, and then heated to form interconnection electrodes made of silver or the like, which are connected to the n$^+$ layer and the p layer on the face and reverse sides of the crystal substrate 15. The crystal substrate 15 with the electrodes thus formed is bonded to a glass panel or a synthetic resin panel by an adhesive, and the assembly is vacuum-sealed, thus producing a solar cell module. The adhesive should preferably be made of EVA (ethylene-vinyl acetate) or the like. The reverse side of the crystal substrate 15 may be protected by a glass sheet, a metal sheet such as of aluminum or stainless steel, or a transparent Teflon film, which is highly water-resistant.

In the above embodiment, after through-holes are formed using a silicon nitride film as a mask, diffused layers are formed. However, after diffused layers are formed, a silicon nitride film may be formed as a mask, and then through-holes may be formed using the mask. According to this modification, the silicon nitride film serves as an anti-reflection film. Also, another method such as screen board as a mask or laser beam punching can be used for forming through-holes in the substrate.

A structure of the solar cell module will be described below with reference to FIG. 4. As shown in FIG. 4, a monocrystalline or polycrystalline silicon substrate 1 is doped into an n$^-$ type, and has an n$^+$ layer on its face side and a p$^+$ layer on its reverse side. The crystalline silicon substrate 1 has a thickness of 150 $\mu$m (micrometers) or less and has a number of minute through-holes 2 defined therein. While the crystalline silicon substrate 1 should preferably have an opening area ratio of about 20 %, the light-blocking ratio of the crystalline silicon substrate 1 may be changed by changing the opening area ratio as desired depending on the application of the solar cell. Metal electrodes 3, 4 are disposed on respective opposite surfaces of the crystalline silicon substrate 1 and connected to interconnections in the module, not shown. The crystalline silicon substrate 1 is vacuum-sealed between glass or transparent synthetic resin panels 5, 6.

Since the crystalline silicon substrate 1 has a relatively small thickness of 150 μm (micrometers) or less, the solar cell module is flexible and can be bonded to a bent glass panel or synthetic resin cover. The crystalline silicon substrate 1 has a p-n junction near its surface, it has high photoelectric conversion efficiency. Inasmuch as highly linear minute through-holes can be formed at a desired opening area ratio by the above etching process based on the application of light, the solar cell is of the see-through type with increased designability and can be manufactured at a low cost.

Although a certain preferred embodiment of the present invention has been shown and described in detail, it should be understood that various changes and modifications may be made therein without departing from the scope of the appended claims.

**Claims**

1. A method of manufacturing a solar cell, comprising:

    bringing a face side of a semiconductor crystal substrate into contact with an electrolytic liquid containing a fluoride;
    placing an electrode in said electrolytic liquid;
    producing a current between said electrode and said semiconductor crystal substrate and applying light to a reverse side of said semiconductor crystal substrate to generate pairs of holes and electrons, said holes moving to said face side of said semiconductor crystal substrate; and
    etching said semiconductor crystal substrate by combining said holes with ions in said electrolytic liquid thereby to form a through-hole in said semiconductor crystal substrate.

2. A method according to claim 1, wherein said semiconductor crystal substrate comprises a monocrystalline silicon substrate or a polycrystalline silicon substrate.

3. A method according to claim 1, wherein said semiconductor crystal substrate comprises a substrate having a thickness of at most 150 μm (micrometers).

4. A method according to claim 1, further comprising:

    depositing an insulating film on a side of said semiconductor crystal substrate;
    forming a multiplicity of openings in said insulating film; and
    etching said semiconductor crystal substrate through said openings for forming a multiplicity of through-holes.

5. A method according to claim 1, wherein said insulating film comprises a silicon nitride film.

6. A method according to claim 1, wherein a mask having a multiplicity of openings is provided for selectively irradiating lights onto the reverse side of said semiconductor crystal substrate.

7. A method according to claim 6, wherein said mask comprises a screen board having a multiplicity of openings.

8. A solar cell comprising a semiconductor crystal substrate having a thickness of at most 150 μm (micrometers) and a multiplicity of through-holes defined therein.

9. A solar cell according to claim 8, wherein said semiconductor crystal substrate comprises a monocrystalline silicon substrate or a polycrystalline silicon substrate.

10. A solar cell according to claim 8, wherein said through-holes are formed by bringing a face side of said semiconductor crystal substrate into contact with an electrolytic liquid containing a fluoride, producing a current through said semiconductor crystal substrate, and applying light to a reverse side of said semiconductor crystal substrate.

11. A solar cell according to claim 8, wherein said through-holes are formed by punching with selectively irradiated laser beam.

# FIG. 1

# FIG. 2

# FIG. 3

# FIG. 4